Europäisches Patentamt

European Patent Office

Office européen des brevets

(11) Publication number: **0 322 737**
**A2**

## (12) EUROPEAN PATENT APPLICATION

(21) Application number: 88121395.3

(51) Int. Cl.⁴ **H01B 1/24**

(22) Date of filing: **21.12.88**

(30) Priority: **25.12.87 JP 326853/87**
**14.07.88 JP 175742/88**

(43) Date of publication of application:
**05.07.89 Bulletin 89/27**

(84) Designated Contracting States:
**DE FR GB**

(71) Applicant: **DAINIPPON INK AND CHEMICALS, INC.**
**35-58, Sakashita 3-chome**
**Itabashi-ku, Tokyo 174(JP)**

(72) Inventor: **Minami, Masamitsu**
**2-15-28-505, Motogou**
**Kawaguchi-shi Saitama-ken(JP)**
Inventor: **Arai, Kazuo**
**1155-2, Shimo-ohkubo**
**Urawa-shi Saitama-ken(JP)**
Inventor: **Kurihara, Eiichi**
**222, Oaza Niijima**
**Kumagaya-shi Saitama-ken(JP)**

(74) Representative: **Kraus, Walter, Dr. et al**
**Patentanwälte Kraus, Weisert & Partner**
**Thomas-Wimmer-Ring 15**
**D-8000 München 22(DE)**

(54) Electrically conductive resin composition and container molded therefrom for use in holding electronic component parts.

(57) An electrically conductive resin composition comprising 10 to 60 % by weight of a thermoplastic resin (A) having a melting point of at least 150 °C and heat distortion temperature of at least 95 °C, 10 to 45 % by weight of an inorganic filler (B) having a plate-like particle shape, 3 to 20 % by weight of inorganic fibers (C), 3 to 30 % by weight of an electrically conductive filler (D) and 3 to 25 % by weight of a thermoplastic elastomer (E), the total amount of the components (A) to (E) being 100 % by weight. A container for holding electronic component parts is provided by molding the electrically conductive resin composition.

EP 0 322 737 A2

This invention relates to an electrically conductive resin composition which is especially suitale for producing containers for holding electronic component parts, such as a tray, for pre-baking a surface mount device (SMD for short) by injection molding, and to such a container obtained by molding the electrically conductive resin composition.

SMD is mounted on a printed wiring base board by soldering. The heat generated at this time tends to cause SMD to absorb moisture and consequently expand and develop cracks. Improvement of the encapsulating resin (increase of adhesion, reduction of stresses, etc.), improvement of the lead frame, and improvement of packing materials (moisture-proof) have been made as measures against it. However, they have not offered a basic solution to the problem. At present, the most effective means is considered to be to remove moisture by prebaking SMD before mounting, and machined articles of metals such as aluminum and stainless steel are used as trays for prebaking.

Metallic trays heretofore used, however, are expensive and have very low productivity in their production, and this defect has been seriously taken up with an expansion of the SMD market. However, no tray of an electrically conductive resin has so far been available which has resistance to static charges and thermal properties resistant to prebaking and eliminates the defects of the metallic trays.

The present inventors made extensive investigations in order to provide a tray which can replace the conventional metallic trays having the above defect. These investigations have led to the finding that by using an electrically conductive resin composition comprising a specific thermoplastic resin, a specific inorganic filler, inorganic fibers, an electrically conductive filler and a thermoplastic elastomer in specified proportions, a tray having resistances to static charges and to prebaking (resistance to warping and deformation) and also excellent mechanical properties such as high impact strength and flexural strength can be obtained at low cost with good productivity by injection molding.

According to this invention, there are provided an electrically conductive resin composition comprising 10 to 60 % by weight of a thermoplastic resin (A) having a melting point of at least 150 °C and a heat distortion temperature of at least 95 °C, 10 to 45 % by weight of an inorganic filler (B) having a plate-like particle shape, 3 to 20 % by weight of inorganic fibers (C), 3 to 30 % by weight of an electrically conductive filler (D) and 3 to 25 % by weight of a thermoplastic elastomer (E), the total amount of the components (A) to (E) being 100 % by weight; and a container for holding electronic component parts which is obtained by molding the electrically conductive resin composition.

The thermoplastic resin (A) has a melting point of at least 150 °C, preferably 160 to 400 °C, and a heat distortion temperature of at least 95 °C, preferably 100 to 270 °C. Examples include polypropylene resins, polyamide resins, thermoplastic polyester resins and polyphenylene sulfide resins.

Specific examples of the polypropylene resins are a homopolymer of propylene, random copolymers and block copolymers of propylene, and polarized polymers of propylene such as acid-modified polymers and silane-modified polymers. The homopolymer, acid-modified polymers and silane-modified polymers are preferred, and the combined use of the homopolymer and the acid-modified polymer and/or silane-modified polymer is especially preferred. The polymer or polymer mixture preferably has a melt index (230 °C, 2.16 kg) of 10 to 50 g/10 min.

The acid-modified polymer is preferably one modified with an unsaturated carboxylic acid such as maleic anhydride or acrylic acid, and the silane-modified polymer is preferably one modified with an alkoxysilane compound such as methacryloxytrimethoxysilane and gamma-aminopropyltriethoxysilane.

Examples of the polyamide resins are 6,6-nylon (polyhexamethyene adipamide), 4,6-nylon (polytetramethylene adipamide), and 6-nylon (polycapramide). 6,6-Nylon and 4,6-nylon are preferred because they have resistance to moisture absorption and even when a large-sized tray with one side measuring longer than 260 mm is molded from the resulting composition, warping, deformation and shrinkage scarcely occur after annealing.

Examples of the thermoplastic polyester resins include polybutylene terephthalate (PBT), and polyethylene terephthalate (PET). The polybutylene terephthalate is preferred. Especially preferably, the thermoplastic polyester or its mixture has a melt index (230 °C, 5 kg) of 5 to 50 g/10 min.

The melting point of the thermoplastic resin (A) can be determined from exothermic peaks obtained when the resin is heated at a temperature elevation rate of 10 °C/min. by means of a differential scanning calorimeter. The heat distorsion temperature of the resin can be measured in accordance with ASTM D-648 (load 4.6 kg/cm²).

The inorganic filler (B) may be an inorganic powder whose particles have a plate-like shape or a thin slice shape. Examples are alumina, kaolin clay, aluminum hydroxide, sericite, talc, molybdenum disulfide, mica and pyrophyllite clay. Mica is especially preferred. Mica usually has a weight average particle diameter of 10 to 1,000 micrometers, preferably 20 to 600 micrometers, and a weight average aspect ratio of at least 10, preferably 20 to 70.

The inorganic fibers (C) may be, for example, glass fibers, carbon fibers, potassium titanate whiskers and stainless steel fibers. The glass fibers are preferred. The glass fibers may be, for example, chopped glass strands and milled glass fibers preferably surface-treated with surface-treating agents. Examples of the surface-treating agents include silane compounds such as gamma-aminopropyltriethoxysilane, and complex chromium compounds such as methacrylate chromic chloride. Usually, the inorganic fibers have a single fiber diameter of 2 to 20 micrometers.

Examples of the electrically conducive filler (D) are carbon black, graphite, copper powder, gold powder and stainless steel powder. Carbon black, particularly one having a specific surface area of 5 to 1400 $m^2/g$, is preferred.

The thermoplastic elastomer (E) may be, for example, a thermoplastic elastomer of the diene, olefin, vinyl, organosilicon or fluorine type. Specific examples include acid-modified ethylene/alpha-olefin copolymers, silane-modified ethylene/alpha-olefin copolymers, epoxy-modified ethylene/alpha-olefin copolymers, ethylene/alpha-olefin copolymers, ethylene/propylene/diene copolymers, ethylene/vinyl acetate copolymer, ethylene/acrylate copolymers, acid-modified ethylene/acrylate copolymers, silane-modified ethylene/acrylate copolymers, epoxy-modified ethylene/acrylate copolymers, hydroxy-modified ethylene/acrylate copolymers, acrylic rubber, acid-modified acrylic rubbers, chlorinated polyethylene, styrene/butadiene rubber (SBR), styrene/butadiene/styrene block copolymer (SBS), styrene/ethylene/butadiene/styrene block copolymer (SEBS), butadiene/acrylonitrile rubber (NBR) and isoprene rubber (IR).

The acid-modified ethylene/alpha-olefin co polymers and silane-modified ethylene/alpha-olefin copolymers are especially preferred as the thermoplastic elastomer (E) when the thermoplastic resin (A) is a polypropylene resin or a polyamide resin. When the thermoplastic resin (A) is a polyester resin, the acid-modified ethylene/alpha-olefin copolymers, acid-modified ethylene/acrylate copolymers, acid-modified acrylic rubbers and silane-modified ethylene/alpha-olefin copolymers may be cited as preferred thermoplastic elastomers (E).

The acid-modified thermoplastic elastomers are preferably those which are modified with unsaturated carboxylic acids, and the silane-modified thermoplastic elastomers are preferably those which are modified with alkoxysilane compounds.

The proportions of the components (A), (B), (C), (D) and (E) used are 10 to 60 % by weight for the thermoplastic resin (A), 10 to 45 % by weight for the inorganic filler (B), 3 to 20 % by weight for the inorganic fibers (C), 3 to 30 % by weight for the electrically conductive filler (D), and 3 to 25 % by weight of the thermoplastic elastomer (E).

When a polypropylene resin or a polyamide resin is used as the thermoplastic resin (A), the composition preferably comprises 25 to 45 % by weight of (A), 20 to 40 % by weight of (B), 3 to 10 % by weight of (C), 5 to 23 % by weight of (D), and 3 to 15 % by weight of (E). When a polyester resin is used as the thermoplastic resin (A), the composition comprises 35 to 55 % by weight of (A), 18 to 40 % by weight of (B), 3 to 13 % by weight of (C), 5 to 23 % by weight of (D) and 3 to 12 % by weight of (E).

The electrically conductive resin composition of this invention may be obtained by simply mixing the predetermined amounts of the components (A) to (E). Usually, it is prepared by, for example, (1) mixing the components (A) to (E) together with optional additives in a drum blender or a Henschel mixer, then melt-kneading them by, for example, a single-screw or twin-screw extruder, an Intensive mixer, a Henschel mixer or a heated kneader, and pelltizing the mixture, or (2) by mixing pellets prepared in advance from the components (A) and (B) or (A) and (E) with the other components and if required an additional supply of component (A) and optional additives, followed by melt-kneading pelletization, as in the method (1) above.

In addition to the components (A) to (E), an antioxidant, a liquid paraffin, an inorganic filler having a non-plate-like particle shape, thermoplastic resins other than the thermoplastic resin (A) may be incorporated, as required, in the electrically conductive resin composition.

The electrically conductive resin composition so obtained may be molded by injection molding, extrusion, compression molding, inflation molding, etc. The injection molding is preferred.

A container for holding electronic component parts, for example a tray for prebaking SMD, can be produced by injection-molding the electrically conductive resin composition of this invention, and then preferably annealing the molded product. The resulting tray for prebaking SMD has good electrical conductivity, is free from warping, deformation, etc, ascribable to prebaking, and has excellent mechanical strength.

The following Examples and Comparative Examples illustrate the present invention more specifically.

EXAMPLES 1-12 AND COMPARATIVE EXAMPLES 1-2

In each run, the starting materials in the mixing proportions indicated in Table 1 were charged into a drum blender, and mixed. Then, the mixture was melt-extruded by a twin-screw extruder (30 mm in screw diameter; L D = 30) at 190 °C, and pelletized to obtain an electrically conductive resin composition.

The resin composition was injection-molded at a molding temperature of 230 °C by an injection molding machine with a mold clamping pressure of 150 tons to give a large-sized tray (335 mm x 180 mm x 2 mm) for prebaking SMD. Warping, thermal shrinkage and precision moldability of the tray were evaluated under the standards described below. Furthermore, the resin composition was injection-molded at a molding temperature of 220 °C by an injection-molding machine with a mold clamping pressure of 40 tons to prepare test pieces. The heat distortion temperature and Izod notched impact strength were measured on the test pieces. The results are shown in Table 1.

Warping of the tray

The tray was subjected to an annealing treatment (left to stand for 2 hours in a Geer's oven at 135 °C, and then allowed to cool at 23 °C for 24 hours), and then placed on a plate having a completely flat surface. The degree of warping was measured by a thickness gauge, and the measured values was rated by the following standards. ⊚: measured value≦1.0 mm

○: 1.0 mm<measured value≦1.5 mm

△: 1.5 mm<measured value≦2.0 mm

X: 2.0 mm<measured value

Thermal shrinkage of the tray

The shrinkages in the longitudinal and transverse directions of the tray subjected to 5 cycles of the annealing treatment were measured as against those of the tray subjected to one cycle of the annealinbg treatment. Larger measured values were employed and rated under the following standards. ⊚: measured value≦0.03 %

○: 0.03 %<measured value≦0.05 %

△: 0.05 %<measured value≦0.07 %

X: 0.07 %<measured value

Precision moldability

The molded state of slender ribs (0.3 mm width, 2.0 mm high) on the back surface of the tray was observed, and rated under the following standards. ⊚: especially good

○: good

△: slightly poor

X: poor

Heat distortion temperature

Measured in accordance with ASTM D-648 (load 66 psi. sample thickness 1 4 inch).

Izod notched impact strength

Measured in accordance with ASTM D-256 (sample thickness 1 8 inch).

4

## COMPARATIVE EXAMPLE 3

The materials in the mixing proportions indicated in Table 1 were mixed in a drum blender, and kneaded in an Intensive mixer at 150 °C. The kneaded mixture was melt-extruded by a vent-equipped single-screw extruder (diameter 40 mm; L/D = 39) at 210 °C, and pelletized to obtain an electrically conductive resin composition. The warping, thermal shrinkage and precision moldability of a tray prepared from it were evaluated as in Example 1. Likewise, its heat distortion temperature and Izod notched impact strength were measured as in Example 1. The results are shown in Table 1.

EP 0 322 737 A2

Table 1

| Item | | 1 | 2 | 3 | 4 | 5 | 6 | 7 | 8 |
|---|---|---|---|---|---|---|---|---|---|
| | | | | | Example | | | | |
| Polypropylene resin (parts) | (A-1)  *1) | 32.5 | 28.5 | 17.0 | 24.5 | 41.5 | 28.5 | 42.5 | 38.5 |
| | (A-2)  *2) | - | - | - | - | - | - | - | - |
| | (A-3)  *3) | - | 10.0 | 10.0 | 10.0 | 10.0 | 10.0 | - | - |
| | (A-4)  *4) | 10.0 | - | - | - | - | - | - | - |
| HIPS  *5)  (parts) | | - | - | - | - | - | - | - | - |
| Mica (parts) | (B-1)  *6) | - | - | - | - | - | 31.5 | - | - |
| | (B-2)  *7) | 31.5 | 31.5 | 37.0 | 31.5 | 31.5 | - | 31.5 | 31.5 |
| Chopped glass strands  *8)  (parts) | | 5.0 | 5.0 | 15.0 | 5.0 | 5.0 | 5.0 | 5.0 | 7.0 |
| Carbon black (parts) | (D-1)  *9) | 16.0 | 16.0 | 12.0 | 16.0 | - | 16.0 | 16.0 | 16.0 |
| | (D-2) *10) | - | - | - | - | 7.0 | - | - | - |
| | (D-3) *11) | - | - | - | - | - | - | - | - |
| Thermoplastic elastomer (parts) | (E-1) *12) | 5.0 | 9.0 | - | 13.0 | 5.0 | 9.0 | - | - |
| | (E-2) *13) | - | - | 9.0 | - | - | - | 5.0 | 7.0 |
| | (E-3) *14) | - | - | - | - | - | - | - | - |
| | (E-4) *15) | - | - | - | - | - | - | - | - |

- to be continued -

EP 0 322 737 A2

Table 1  continued

| | Item | Example | | | | | | | |
|---|---|---|---|---|---|---|---|---|---|
| | | 1 | 2 | 3 | 4 | 5 | 6 | 7 | 8 |
| Physical properties | Heat distortion temperature ($^{O}$C) | 150 | 150 | 158 | 135 | 140 | 150 | 148 | 135 |
| | Izod notched impact strength (kg–cm/cm) | 2.7 | 4.0 | 3.0 | 8.0 | 3.0 | 4.0 | 3.6 | 6.6 |
| | Warping of the tray | ◎ | ◎ | ◎ | ○ | ○ | ◎ | ◎ | ○ |
| | Thermal shrinkage of the tray | ◎ | ◎ | ◎ | ○ | ◎ | ◎ | ◎ | ◎ |
| | Precision moldability | ◎ | ◎ | ○~△ | ◎ | ○~△ | ◎ | ◎ | ◎ |

– to be continued –

Table 1 continued

| Item | | Example | | | | Comparative Example | | |
|---|---|---|---|---|---|---|---|---|
| | | 9 | 10 | 11 | 12 | 1 | 2 | 3 |
| Polypropylene resin (parts) | (A-1) *1) | 24.5 | – | 28.5 | 27.5 | – | 61.0 | – |
| | (A-2) *2) | – | 38.5 | – | – | – | – | – |
| | (A-3) *3) | 10.0 | – | 10.0 | 10.0 | 10.0 | 5.0 | – |
| | (A-4) *4) | – | – | – | – | – | – | – |
| HIPS *5) (parts) | | – | – | – | – | – | – | 58.0 |
| Mica (parts) | (B-1) *6) | – | – | – | – | – | – | – |
| | (B-2) *7) | 31.5 | 31.5 | 31.5 | 31.5 | 50.0 | 10.0 | – |
| Chopped glass strands *8) (parts) | | 5.0 | 5.0 | 8.0 | 5.0 | 20.0 | 3.0 | – |
| Carbon black (parts) | (D-1) *9) | – | 16.0 | 15.0 | 16.0 | 10.0 | 18.0 | 27.0 |
| | (D-2) *10) | – | – | – | – | – | – | – |
| | (D-3) *11) | 20.0 | – | – | – | – | – | – |
| Thermoplastic elastomer (parts) | (E-1) *12) | 9.0 | 9.0 | 7.0 | – | 10.0 | 3.0 | – |
| | (E-2) *13) | – | – | – | – | – | – | – |
| | (E-3) *14) | – | – | – | 10.0 | – | – | – |
| | (E-4) *15) | – | – | – | – | – | – | 15.0 |

– to be continued –

EP 0 322 737 A2

Notes to Table 1

Table 1 continued

| | Item | Example | | | | Comparative Example | | |
|---|---|---|---|---|---|---|---|---|
| | | 9 | 10 | 11 | 12 | 1 | 2 | 3 |
| Physical properties | Heat distortion temperature ($^o$C) | 150 | 140 | 150 | 150 | Molding not well per-formed | 110 | 80 |
| | Izod notched impact strength (kg–cm/cm) | 3.4 | 4.5 | 4.0 | 2.5 | | 5.0 | 5.0 |
| | Warping of the tray | ◎ | ○ | ◎ | ◎ | | X | X |
| | Thermal shrinkage of the tray | ◎ | ◎ | ◎ | ◎ | | X | X |
| | Precision moldability | ○~△ | ○ | ◎ | ○ | | ◎ | ◎ |

*1) Polypropylene resin (A-1): UBE Polypro J-130G, polypropylene produced by Ube Industries. Ltd. (MI = 25 g/10 min.)

*2) Polypropylene resin (A-3): UBE Polypro J-830HK, block copolymer produced by Ube Industries, Ltd. (MI = 30 g/10 min.)

*3) Poylpropylene resin (A-3): silane-modified polypropylene produced by Ube Industries, Ltd. (MI = 10 g/10 min.)

*4) Polyproylene resin (A-4): acrylic acid-modified polypropylene produced by Dainippon Ink and Chemicals, Inc. (MI = 40 g/10 min.)

*5) HIPS: high impact polystyrene produced by Dainippon Ink & Chemicals, Inc. (DIC Styrene MH-6100. MI = 6 g/10 min.)

*6) Mica (B-1): weight average particle diameter = 40 micrometers, aspect ratio = 30.

*7) Mica (B-2): weight average particle diameter = 70 micrometers aspect ratio = 50.

*8) Chopped glass strands (fiber diameter 13 micrometers)

*9) Carbon black (D-1): specific surface area 50 $m^2/g$

*10) Carbon black (D-2): specific surface area 1000 $m^2/g$

*11) Carbon black (D-3): specific surface area 28 $m^2/g$

*12) Thermoplastic elastomer (E-1) ethylene/alpha-olefin copolymer produced by Mitsui Petrochemical Industries, Ltd. (TAFMER P-0280, MI = 6 g/10 min.)

*13) Thermoplastic elastomer (E-2): Maleic acid-modified ethylene/alpha-olefin copolymer (TAFMER MP-0610, MI = 0.5 g/10 min.

*14) Thermoplastic elastomer (E-3): olefinic thermoplastic elastomer (TPE produced by Sumitomo Chemical Co., Ltd. (TPE 9001, MI = 0.9 g/10 min.)

*15) Thermoplastic elastomer (E-4): styrene/butadiene/styrene block copolymer produced by Japan Synthetic Rubber Co., Ltd. (TR-2000, MI = 3.0 g/10 min.)

## EXAMPLES 13-27 AND COMPARATIVE EXAMPLES 4-6

In each run, the starting materials in the mixing proportions indicated in Table 2 were charged into a drum blender, and mixed. Then, the mixture was melt-extruded by a twin-screw extruder (30 mm in screw diameter; L/D = 30) at 250 °C, and pelletized to obtain an electrically conductive resin composition.

The resin composition was injection-molded at a molding temperature of 270 °C by an injection molding machine with a mold clamping pressure of 150 tons to give a large-sized tray (335 mm x 180 mm x 2 mm) for prebaking SMD. Warping, thermal shrinkage and precision moldability of the tray were evaluated as in Example 1. Furthermore, the resin composition was injection-molded at a molding temperature of 260 °C by an injection-molding machine with a mold clamping pressure of 40 tons to prepare test pieces. The heat distortion temperature and Izod notched impact strength were measured on the test pieces as in Example 1. The results are shown in Table 2.

## COMPARATIVE EXAMPLE 7

The materials in the proportions shown in Table 2 were charged in a drum blender and mixed. and kneaded in an Intensive mixer at 150 °C. The kneaded mixture was melt-extruded by a vent-equipped single-screw extruder (diameter 40 mm, L/D = 29) at 210 °C and pelletized to obtain an electrically conductive resin composition. The warping, thermal shrinkage and precision moldability of a tray were evaluated, and the heat distortion temperature and Izod notched impact strength of the composition were measured. In the same way as in Example 1 except that the tray molding temperature was changed to 240 °C. and the injecting molding temperature for the test pieces was changed to 230 °C. The results are shown in Table 2.

EP 0 322 737 A2

## Table 2

| Item | | Example | | | | | | | | |
|------|---|---|---|---|---|---|---|---|---|---|
| | | 13 | 14 | 15 | 16 | 17 | 18 | 19 | 20 | 21 |
| PBT  *16)   (parts) | | 49.0 | 39.0 | 49.0 | 49.0 | 49.0 | 49.0 | 44.0 | 30.0 | 30.0 |
| PET  *17)   (parts) | | – | – | – | – | – | – | – | – | – |
| Elastomer-containing PBT compound  *18) (parts) | | – | – | – | – | – | – | – | 24.0 | 24.0 |
| HIPS  *5)   (parts) | | – | – | – | – | – | – | – | – | – |
| Mica (parts) | (B-1)   *6) | 20.0 | 20.0 | 20.0 | 20.0 | 20.0 | 20.0 | 20.0 | 20.0 | – |
| | (B-2)   *7) | – | – | – | – | – | – | – | – | 20.0 |
| Chopped glass strands  *8) (parts) | | 10.0 | 10.0 | 10.0 | 10.0 | 10.0 | 10.0 | 10.0 | 10.0 | 10.0 |
| Carbon black (parts) | (D-1)   *9) | 16.0 | 16.0 | 16.0 | 16.0 | 16.0 | 16.0 | 16.0 | 16.0 | 16.0 |
| | (D-2) *10) | – | – | – | – | – | – | – | – | – |
| | (D-3) *11) | – | – | – | – | – | – | – | – | – |

Table 2 continued

| Item | | 13 | 14 | 15 | 16 | 17 | 18 | 19 | 20 | 21 |
|---|---|---|---|---|---|---|---|---|---|---|
| | | **Example** | | | | | | | | |
| Thermoplastic elastomer (parts) | (E-5) *19) | 5.0 | 15.0 | − | − | − | − | − | − | − |
| | (E-6) *20) | − | − | 5.0 | − | − | − | − | − | − |
| | (E-7) *21) | − | − | − | 5.0 | − | − | − | − | − |
| | (E-8) *22) | − | − | − | − | 5.0 | − | − | − | − |
| | (E-9) *23) | − | − | − | − | − | 5.0 | − | − | − |
| | (E-4) *15) | − | − | − | − | − | − | 10.0 | − | − |
| Physical properties | Heat distortion temperature ($^{O}$C) | 185 | 180 | 185 | 185 | 190 | 190 | 180 | 185 | 185 |
| | Izod notched impact strength (kg-cm/cm) | 2.5 | 3.5 | 2.2 | 2.8 | 2.2 | 2.0 | 2.0 | 2.8 | 2.8 |
| | Warping of the tray | ◎ | ○ | ◎ | ◎ | ◎ | ◎ | ◎ | ◎ | ◎ |
| | Thermal shrinkage of the tray | ◎ | ◎ | ◎ | ◎ | ◎ | ◎ | ◎ | ◎ | ◎ |
| | Precision moldability | ◎ | ○ | ◎ | ◎ | ◎ | ○ | ○ | ◎ | ◎ |

− to be continued −

Table 2 continued

| Item | | Example | | | | | | Comparative Examle | | | |
|---|---|---|---|---|---|---|---|---|---|---|---|
| | | 22 | 23 | 24 | 25 | 26 | 27 | 4 | 5 | 6 | 7 |
| PBT *16) (parts) | | 36.0 | 29.0 | 29.0 | 26.0 | 19.0 | – | 43.0 | 17.0 | – | – |
| PET *17) (parts) | | – | – | – | – | – | 49.0 | – | – | – | – |
| Elastomer-containing PBT compound *18) (parts) | | 19.0 | 24.0 | 24.0 | 24.0 | 24.0 | – | 24.0 | 24.0 | 20.0 | – |
| HIPS *5) (parts) | | – | – | – | – | – | – | – | – | – | 37.0 |
| Mica (parts) | (B-1) *6) | 24.0 | 16.0 | 30.0 | 20.0 | 30.0 | 20.0 | 10.0 | 45.0 | 50.0 | 20.0 |
| | (B-2) *7) | – | – | – | – | – | – | – | – | – | – |
| Chopped glass strands *8) (parts) | | 5.0 | 15.0 | 10.0 | 10.0 | 15.0 | 10.0 | 3.0 | – | 20.0 | 10.0 |
| Carbon black (parts) | (D-1) *9) | 16.0 | 16.0 | – | – | 12.0 | 16.0 | 20.0 | 14.0 | 10.0 | 18.0 |
| | (D-2) *10) | – | – | 7.0 | – | – | – | – | – | – | – |
| | (D-3) *11) | – | – | – | 20.0 | – | – | – | – | – | – |

– to be continued –

EP 0 322 737 A2

Table 2 continued

| Item | | | Example | | | | | | Comparative Example | | | |
|---|---|---|---|---|---|---|---|---|---|---|---|---|
| | | | 22 | 23 | 24 | 25 | 26 | 27 | 4 | 5 | 6 | 7 |
| Thermoplastic elastomer (parts) | | (E-5) *19) | – | – | – | – | – | – | – | – | – | – |
| | | (E-6) *20) | – | – | – | – | – | – | – | – | – | – |
| | | (E-7) *21) | – | – | – | – | – | 5.0 | – | – | – | – |
| | | (E-8) *22) | – | – | – | – | – | – | – | – | – | – |
| | | (E-9) *23) | – | – | – | – | – | – | – | – | – | – |
| | | (E-4) *15) | – | – | – | – | – | – | – | – | – | 15.0 |
| Physical properties | Heat distortion temperature ($^{o}$C) | | 190 | 185 | 190 | 185 | 180 | 200 | 120 | 190 | Molding not well performed | 80 |
| | Izod notched impact strength (kg-cm/cm) | | 2.2 | 3.5 | 3.0 | 2.2 | 2.0 | 2.0 | 3.0 | 1.4 | | 2.2 |
| | Warping of the tray | | ◎ | ○ | ◎ | ◎ | ○ | ○ | X | ◎ | | X |
| | Thermal shrinkage of the tray | | ◎ | ◎ | ◎ | ◎ | ◎ | ◎ | X | ◎ | | X |
| | Precision moldability | | ◎ | ○ | ◎ | ◎ | ○ | ○ | ◎ | ○ | | ○ |

\*16) PBT: polybutylene terephthalate (NOBADUR 5020, a product of Mitsubishi Chemical Industries, Ltd.)

\*17) PET: polyethylene terephthalate produced by Kuraray Co., Ltd. (Kurapet KL236).

\*18) Elastomer-containing PBI compound: obtained by melt-kneading NOBADUR and maleic acid-modified acrylate) in a weight ratio of 80:20 and then pelletizing the mixture.

\*19) Thermoplastic elastomer (E-5): maleic acid-modified ethylene/alpha-olfin copolymer produced by Japan Synthetic Rubber Co., Ltd. (MEP-9603; MI = 0.4 g/10 min.)

\*20) Thermoplastic elastomer (E-6): Silane-modified ethylene/alpha-olefin copolymer produced by Japan Synthetic rubber Co., Ltd.

\*21) Thermoplastic elastomer (E-7): Maleic acid-modified acrylic rubber (acrylic acid 5 %. ethyl acrylate 95 %) produced by Japan Synthetic Rubber Co., Ltd.

\*22) Thermoplastic elastomer (E-8): Maleic acid-modified ethylene/acrylate copolymer produced by Sumitomo Chemical Co., Ltd. (BONDINE AX-8390; MI = 7.0 g/10 min.)

\*23) Thermoplastic elastomer (E-9): Ethylene/ethyl acrylate copolymer produced by Nippon Unicar Company, Ltd. (DPSJ-6182, MI = 1.5 g/10 min.)

\*5), \*6), \*7), \*8), \*9), \*10), \*11) and \*15) are the same as the notes to Table 1.

## EXAMPLES 28-29

The materials in the mixing proportions indicated in Table 3 were fed into a drum blender and mixed, and melt-extruded by a twin-screw extruder (diameter 30 mm; L/D = 30) at 300 °C for 4,6-nylon and 270 °C for 6,6-nylon and pelletized to obtain an electrically conductive resin composition.

The resin composition was then injection-molded at a molding temperature of 310 °C for 4,6-nylon or 290 °C for 6,6-nylon by an injection-molding machine with a mold clamping pressure of 150 tons to form a large-sized tray (335 mm x 180 mm x 2 mm) for prebaking SMD. The warping, thermal shrinkage and precision moldability of the tray were evaluated in the same way as in Example 1. The resin composition was injection-molded at a molding temperature of 280 °C for 6,6-nylon or 300 °C for 6,6-nylon by an injection-molding machine with a mold clamping pressure to obtain test pieces. The heat distortion temperature and the Izod notched impact strength of the test pieces were measured in the same way as in Example 1. The results are shown in Table 3.

## EXAMPLE 30

Using the materials in the proportions shown in Table 3, an electrically conductive resin composition was prepared in the same way as in Example 1. A small-sized tray (225 mm x 115 mm x 2 mm) for prebaking SMD was obtained by injection molding as in Example 1, and its warping, thermal shrinkage and precision moldability were evaluated as in Example 1. The heat distortion temperature and the Izod notched impact strength were measured as in Example 1. The results are shown in Table 3.

## EXAMPLES 31-32

Using the materials in the proportions shown in Table 3, an electrically conductive resin composition was prepared in the same way as in Example 13. A small-sized tray (225 mm x 115 mm x 2 mm) for prebaking SMD was obtained by injection molding as in Example 1, and its warping, thermal shrinkage and precision moldability were evaluated as in Example 1. The heat distortion temperature and the Izod notched impact strength were measured as in Example 1. The results are shown in Table 3.

## EXAMPLES 33-34

Using the materials in the proportions shown in Table 3, an electrically conductive resin composition was prepared in the same way as in Example 28 to 29. A small-sized tray (225 mm x 115 mm x 2 mm) for prebaking SMD was obtained by injection molding as in Example 1, and its warping, thermal shrinkage and precision moldability were evaluated as in Example 1. The heat distortion temperature and the Izod notched impact strength were measured as in Example 1. The results are shown in Table 3.

EP 0 322 737 A2

Table 3

| Item | Example | | | | | | |
|---|---|---|---|---|---|---|---|
| | 28 | 29 | 30 | 31 | 32 | 33 | 34 |
| 4,6 Nylon  *24)  (parts) | 42.5 | - | - | - | - | - | - |
| 6,6-Nylon  *25)  (parts) | - | 38.5 | - | - | - | 38.5 | - |
| 6-Nylon  *26)  (parts) | - | - | - | - | - | - | 39 |
| Polypropylene resin (A-1)  *1)  (parts) | - | - | 21.5 | - | - | - | - |
| Polypropylene resin (A-3)  *3)  (parts) | - | - | 10.0 | - | - | - | - |
| PBT  *16)  (parts) | - | - | - | 19.0 | - | - | - |
| PET  *17)  (parts) | - | - | - | - | 44.0 | - | - |
| Elastomer-containing PBT compound  *18)  (parts) | - | - | - | 24.0 | - | - | - |
| Mica  (parts) | (B-1)  *6) | - | - | - | 30.0 | 20.0 | - | 30 |
| | (B-2)  *7) | 31.5 | 31.5 | 31.5 | - | - | 31.5 | - |
| Chopped glass strands  *8)  (parts) | 5.0 | 7.0 | 5.0 | 15.0 | 15.0 | 7.0 | 10.0 |
| Carbon black (D-1)  *9)  (parts) | 16.0 | 16.0 | 16.0 | 12.0 | 16.0 | 16.0 | 16.0 |

- to be continued -

EP 0 322 737 A2

Table 3 (continued)

| Item | | | Example | | | | | | |
|---|---|---|---|---|---|---|---|---|---|
| | | | 28 | 29 | 30 | 31 | 32 | 33 | 34 |
| Thermoplastic elastomer (parts) | | (E-1) *12) | - | - | 16.0 | - | - | - | - |
| | | (E-2) *13) | 5.0 | 7.0 | - | - | - | 7.0 | - |
| | | (E-5) *19) | - | - | - | - | - | - | 5.0 |
| | | (E-7) *21) | - | - | - | - | 5.0 | - | - |
| Physical properties | Heat-distortion temperature ($^O$C) | | 280 | 200 | 130 | 180 | 200 | 200 | 180 |
| | Izod impact strength (kg-cm/cm) | | 3.6 | 4.0 | 7.0 | 2.0 | 3.0 | 4.0 | 3.5 |
| | Warping of the tray | | ◎ | ○ | ◎ | ◎ | ◎ | ◎ | ◎ |
| | Thermal shrinkage of the tray | | ◎ | ◎ | ◎ | ◎ | ◎ | ◎ | ○ |
| | Precision moldability | | ◎ | ◎ | ◎ | ◎ | ◎ | ◎ | ◎ |
| Size of the tray | | | 335mmx180mmx2mm | 225mm x 115mm x 2mm | | | | | |

Notes to Table 3

*24) 4,6-nylon: Unitika Nylon F5000 produced by Unitika Co., Ltd.
*25) 6,6-nylon: Ube Nylon 2020B produced by Ube Industries, Ltd.
*26) 6-Nylon: Ube Nylon 1011FB produced by Ube Industries, Ltd.
*1), *3), *6), *7), *8), *9), *12), *13), *16), *17), *18), *19) and *21) were the same note to Tables 1 and 2.

## Claims

1. An electrically conductive resin composition comprising 10 to 60 % by weight of a thermoplastic resin (A) having a melting point of at least 150 °C and a heat distortion temperature of at least 95 °C, 10 to 45 % by weight of an inorganic filler (B) having a plate-like particle shape, 3 to 20 % by weight of inorganic fibers (C), 3 to 30 % by weight of an electrically conductive filler (D) and 3 to 25 % by weight of a thermoplastic elastomer (E), the total amount of the components (A) to (E) being 100 % by weight.

2. The composition of claim 1 in which the thermoplastic resin (A) is a polypropylene resin, a polyamide resin or a polyester resin.

3. The composition of claim 1 in which the inorganic filler (B) is mica, the inorganic fibers (C) are glass fibers, and the electrically conductive filler (D) is carbon black.

4. The composition of claim 3 in which the thermoplastic resin (A) is a polypropylene resin and which comprises 25 to 45 % by weight of (A), 20 to 40 % by weight of (B), 3 to 10 % by weight of (C), 5 to 23 % by weight of (D), and 3 to 15 % by weight of (E).

5. The composition of claim 3 in which the thermoplastic resin (A) is a polyamide resin and which comprises 25 to 45 % by weight of (A), 20 to 40 % by weight of (B), 3 to 10 % by weight of (C), 5 to 23 % by weight of (D), and 3 to 15 % by weight of (E).

6. The composition of claim 3 in which the thermoplastic resin (A) is a polyester resin and which comprises 35 to 55 % by weight of (A), 18 to 40 % by weight of (B), 3 to 13 % by weight of (C), 5 to 23 % by weight of (D), and 3 to 12 % by weight of (E).

7. A container for holding electronic component parts, which is obtained by molding an electrically conductive resin composition comprising 10 to 60 % by weight of a thermoplastic resin (A) having a melting point of at least 150 °C and a heat distortion temperature of at least 95 °C, 10 to 45 % by weight of an inorganic filler (B) having a plate-like particle shape, 3 to 20 % by weight of inorganic fibers (C), 3 to 30 % by weight of an electrically conductive filler (D) and 3 to 25 % by weight of a thermoplastic elastomer (E), the total amount of the components (A) to (E) being 100 % by weight.

8. The container of claim 7 in which the thermoplastic resin (A) is a polypropylene resin, a polyamide resin or a polyester resin.

9. The container of claim 7 in which the inorganic filler (B) is mica, the inorganic fibers (C) are glass fibers, and the conductive filler (D) is carbon black.

10. The container of claim 9 in which the thermoplastic resin (A) is a polypropylene resin and which comprises 25 to 45 % by weight of (A), 20 to 40 % by weight of (B), 3 to 10 % by weight of (C), 5 to 23 % by weight of (D), and 3 to 15 % by weight of (E).

11. The container of claim 9 in which the thermoplastic resin (A) is a polyamide resin and which comprises 25 to 45 % by weight of (A), 20 to 40 % by weight of (B), 3 to 10 % by weight of (C), 5 to 23 % by weight of (D), and 3 to 15 % by weight of (E).

12. The container of claim 9 in which the thermoplastic resin (A) is a polyester resin and which comprises 35 to 55 % by weight of (A), 18 to 40 % by weight of (B), 3 to 13 % by weight of (C), 5 to 23 % by weight of (D), and 3 to 12 % by weight of (E).